Europäisches Patentamt

European Patent Office

Office européen des brevets

(11) Publication number: **0 238 161**
**A2**

## EUROPEAN PATENT APPLICATION

(21) Application number: **87300289.3**

(51) Int. Cl.⁴: **H05K 13/00**

(22) Date of filing: **14.01.87**

(30) Priority: **14.02.86 US 829638**

(43) Date of publication of application:
**23.09.87 Bulletin 87/39**

(84) Designated Contracting States:
**DE FR GB**

(71) Applicant: **CONTROL DATA CORPORATION**
**8100-34th Avenue South**
**Minneapolis Minnesota 55440(US)**

(72) Inventor: **Eidal, Russell Clair**
**717 Westhaven Road**
**Chippewa Falls WI 54749(US)**

(74) Representative: **Caro, William Egerton et al**
**J. MILLER & CO. Lincoln House 296-302 High**
**Holborn**
**London WC1V 7JH(GB)**

(54) **A backup sheet for backing a worksheet during a small bore drilling process.**

(57) A backup sheet for backing a worksheet during a small bore drilling process comprises a layer - (20,22) of polyimide, fluorocarbon or high temperature polycarbonate material on at least one side of a core (10,12,14,16,18).

*Fig.2*

# A BACKUP SHEET FOR BACKING A WORKSHEET DURING A SMALL BORE DRILLING PROCESS

This invention relates to backup sheets for backing worksheets during small bore drilling process, for example, during drilling of small holes in worksheets of polyimide and modified epoxy materials.

Multilayer printed circuit boards are typically constructed of an insulating layer separating conductive layers of, for example, copper. Standard multilayer boards, having 2 to 20 layers, range in thickness from 0.4 mm to about 3.2 mm (0.015 inch to about 0.125 inch) each. Heretofore, it was possible successfully to drill holes down to about 0.2 mm (0.006 inch) in diameter in printed circuit boards constructed of epoxy/glass using a backup sheet of a material such as LCOA, a material commercially available from Laminating Company of America of Escondido, California. However, more recently printed circuit boards have been constructed of polyimide/glass, polyimide/polyamide and modified epoxy bismaleimide triazine (BT)/glass materials. These particular materials are hard or tough granular structures, such that drilling them is more difficult than in prior materials. It has not been possible to drill holes in these materials at the small diameters previously achieved using existing backup sheets of, for example, LCOA. Particularly, it has been found that attempts to drill apertures smaller than about 0.44 mm (0.0165 inch) in granular structures, having thicknesses greater than about 1.7 mm (0.065 inch), results in a high instance of drill bit breakage. Further, it has been found impractical to attempt to drill holes in such materials below about 0.3 mm (0.0135 inch) in diameter. In particular, drill bit breakage occurs largely due to compaction of the granular material in the flutes of the bit, which material "binds" against the wall of the aperture during bit retraction, causing bit breakage.

It has been found, however, that if a backup sheet also includes a hard or tough granular material, the incidence of drill bit breakage is significantly reduced. Without being bound to any theory, it is thought that when drilling small bores in circuit boards of hard or tough granular material (polyimide/glass and modified epoxy BT/glass materials), grains (polyimide and epoxy BT grains) pack in the flutes of the drill bit. As the drill bit is retracted, the grains impacted in the flutes bind against the side walls of the bore, and the stress of retraction breaks the drill bit. However, when using a backup sheet containing a hard or tough granular material of, for example, polyimide material the flutes are cleaned prior to retraction. When the drill bit enters the polyimide material of the backup sheet, the polyimide material remains in a one-piece sliver, which can withstand extremely high temperatures and thus remain a "slippery" lubricant to the flutes. The sliver of polyimide material from the backup sheet thus forces granular debris from the flutes of the drill bit prior to retraction of the bit.

According to the present invention there is provided a backup sheet for backing a worksheet during a small bore drilling process characterised by a layer of polyimide, fluorocarbon or high temperature polycarbonate material on at least one side of a core.

Preferably the or each layer consists of a layer of polyimide material substantially 0.05 mm (0.002 inch) thick fixed to said core with a layer of acrylic adhesive substantially 0.025 mm (0.001) inch thick.

In the illustrated embodiment the core comprises compressed woodchips and/or sawdust and a binder and aluminium layers adhered to opposite planar surfaces thereof.

The backup sheet may be in combination with a worksheet consisting of any one of polyimide/glass, polyimide/polyamide and modified epoxy bismaleimide triazine/glass.

The invention is illustrated, merely by way of example, in the accompanying drawings, in which:-

Figure 1 is a sectional view of a conventional backup sheet; and

Figure 2 is a sectional view of a backup sheet according to the present invention for backing a worksheet during a small bore drilling process.

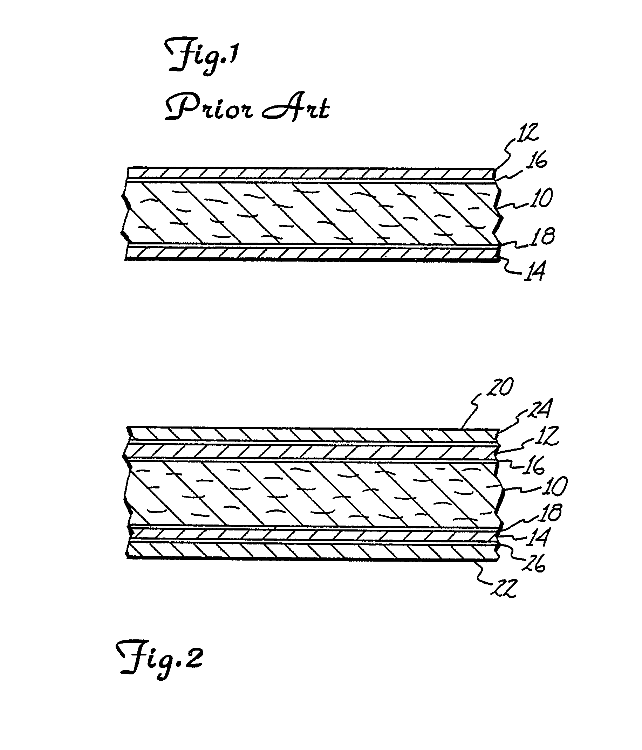

Referring to Figure 1, there is illustrated a sectional view of a conventional backup sheet for backing a worksheet during a small bore drilling process. This backup sheet is known as an LCOA backup sheet and consists of a layer 10 of compress woodchips and/or sawdust in a bonding agent with aluminium foil layers 12,14 adhered to opposite sides thereof by adhesive layers 16,18.

As shown in Figure 2 a backup sheet according to the present invention for backing a worksheet during a small bore drilling process consists of the conventional backup sheet illustrated in Figure 1 as a core with additional layers 20,22 consisting of 0.05 mm (0.002 inch) thick of polyimide material, commercially available from DuPont as KAPTON or KAPTON H (Trade Marks). The layers 20,22 are adhered to the aluminium foil layers 12,14 by a 0.03 mm (0.001 inch) thick layer of an acrylic adhesive. Conveniently, the polyimide layers may be applied to the aluminium foil layers with the acrylic adhesive in a heated lamination - (rolling) process.

Tests of backup sheets according to the present invention have been conducted. In a first test a conventional LCOA backup sheet was used with a circuit board having ten layers of polyimide and a thickness of 1.8 mm (0.70 inch). In this first test, 600 bores were drilled using drill bits having a diameter of 0.34 mm (0.0135 inch) at a spindle speed of 8000 rpm. With a drill feed of 100 cm/min (40 inch/min), an average of one broken bit occurred in each 650 bores. In a second test, the same conditions as the first test were used, except that the drill bit feed rate was increased to 150 cm/min (60 inch/min). Nearly constant bit breakage occurred in the second test. In similar tests using smaller drill bits of the order of 0.30 mm (0.012 inch), 0.28 mm (0.011 inch) and 0.25 mm (0.010 inch) at spindle speeds of 8000 rpm and drill feed rate of 125 cm/min (50 inch/min) broken bits occurred in approximately each 20 bores.

In another set of tests employing a backup sheet according to the present invention with polyimide layers 20,22 adhered to the conventional LCOA backup sheet with an acrylic adhesive, at drill feed rates ranging between 75 and 250 cm/min (30 and 100 inch/min) and spindle speeds of 8000 rpm, drilling the same type of circuit board as in the first test, no broken bits occurred in 1500 bores using 0.34 mm (0.0135 inch) diameter bits, no broken bits occurred in 1500 bores with a drill size of 0.28 mm (0.011 inch) and no broken bits occurred in 1000 bores using a drill size of 0.25 mm - (0.010 inch).

Testing on printed circuit boards containing copper layers resulted in no broken drill bits in over 50,000 bores. Micro sectioning of multilayer circuit boards drilled with a backup sheet according to the present invention showed no degradation in hole quality.

The present invention thus provides an effective backup sheet for backing worksheets during small bore drilling processes. Particularly, the backup sheets have proved useful in connection with drilling materials constructed of polyimide/glass, polyimide/KEVLAR (Trade Mark for poly(1,4-phenyleneterephthalamide)) and modified epoxy bismaleimide triazine (BT)/glass materials. In addition, although polyimide is disclosed as being the preferred material for the layers 20,22 it has also been found that fluorocarbons, such as polytetrafluoroethylene (TEFLON -Trade Mark) and high temperature polycarbonates are also useful for the layers 20,22.

One type of polyimide material that may be used with the present invention has flexural strength and modulus of $5 \times 10^7$ kg/m² (70000 psi) and $2.8 \times 10^7$ kg/m² (40000 psi), respectively, tensile strength of about $3.5 \times 10^7$ kg/m² (50000 psi), compressure strength of about $3.5 \times 10^7$ kg/m² (50000 psi), and short beam shear strength of about $6 \times 10^6$ kg/m² (8650 psi) at room temperature (25°c).

## Claims

1. A backup sheet for backing a worksheet during a small bore drilling process characterised by a layer (20,22) of polyimide, fluorocarbon or high temperature polycarbonate material on at least one side of a core (10,12,14,16,18).

2. A backup sheet as claimed in claim 1 characterised in that the or each layer (20,22) consists of a layer of polyimide material substantially 0.05 mm (0.002 inch) thick fixed to said core with a layer (24,26) of acrylic adhesive substantially 0.025 mm (0.001 inch) thick.

3. A backup sheet as claimed in claim 1 or 2 characterised in that the core comprises compressed woodchips and/or sawdust (10) and a binder and aluminium layers (12,14) adhered to opposite planar surfaces thereof.

4. A backup sheet as claimed in any preceding claim in combination with a worksheet characterised by consisting of any one of polyimide/glass, polyimide/polyamide and modified epoxy bismaleimide triazine/glass.

Fig.1

Prior Art

Fig.2